# EUROPEAN PATENT APPLICATION

(11) **EP 1 788 711 A1**
(43) Date of publication of application: **23.05.2007**
(21) Application number: 05770403.3
(22) Date of filing: 05.08.2005
(51) Int. Cl.: H03M 13/47, H04L 1/00

(54) **ERROR CORRECTION DEVICE**

(30) Priority: 24.08.2004 JP 2004243436
(71) Applicant: Pioneer Corporation, Tokyo 1538654 (JP)
(72) Inventor: HOSHINO, Hironobu c/o Pioneer Corp. Kawagoe Works, Saitama 3508555 (JP); UCHIYAMA, Kazuhiko c/o Pioneer Corp. Kawagoe Works, Saitama 3508555 (JP); SHIBATA, Koji c/o Pioneer Corp. Kawagoe Works, Saitama 3508555 (JP)
(74) Representative: Manitz, Finsterwald & Partner GbR
(86) International application number: PCT/JP2005/014857
(87) International publication number: WO 2006/022155

(57) **Abstract**

The data error correcting device is provided with: a error correction means which performs an error correction process on a time-series of bits of input data, and produces corrected data and parameters showing an error sensing status at the time of correction; an estimated data producing means which responds to an instruction for data estimation, and produces estimated data configured of a time-series of bits resulting from adjustment of a time-series of bits of input data; and a control means which produces a data estimation instruction based on information included in the corrected data and parameters, and supplies the estimated data to the error correction means instead of the input data.

## Description

### Technical Field

The present invention relates to an error correcting device, and an error correcting method for the device, etc.

### Background Art

In order to redress a data error caused by radio wave interference owing to bad weather, mixing of noise or the like when data signal transmission is performed in digital broadcast of BS, CS, terrestrial digital or the like, an error correction process according to an error correction code is performed in a receiving device for digital broadcast. As an error correction code like this, Reed-Solomon code (hereinafter, simply referred to as "RS code") is generally used, which is a kind of multivalued BCH codes. The feature of the RS code is that a plurality of bits included in transmission data are handled as one block, and an error correction process is performed by such block. The RS code is effective against burst errors which occur on a time-series of bits of transmission data concentrically. While the RS code has such advantage on one hand, it has a disadvantage such that The RS code is less effective against a random error which occurs randomly on a time-series of bits of transmission data because error correction is performed in blocks on the other hand.

For instance, in the case of RS (204, 188) code composed of 188 bytes of information code and 16 bytes of inspection code, i.e. 204 bytes of code length in total, the following are possible: to correct up to 8 bytes of error with respect to a burst error; and to detect up to 16 error blocks. However, as for a random error caused by e.g. Gaussian noise, it becomes difficult to correct even no more than 9 bits of error.

In order to compensate for such disadvantage, a technique of performing an error correction process with a combination of a convolutional code effective against a random error and the RS code has been disclosed in the past (Patent Document 1: Japanese Patent Application Kokai : JP-A-2000-286719). However, such error correction method according to the prior art has had a problem such that the configuration of a receiving device and the procedure of its error correction process are made more complicated as shown in the document.

### Disclosure of the Invention

One example of problems that the present invention aims at solving is to provide an error correcting device and the like which enable the rise in an error correction rate using a easier method in comparison to a conventional error correcting device and the like.

According to Claim 1, the error correcting device which executes an error correction process on supply data supplied from an information source features including: correction processing means which accepts input of the supply data, performs an error correction process on the supply data, and produces corrected data based on the input data, and error-state data showing a status of a remaining error in the corrected data; detection means which detects the remaining error included in the corrected data based on the error-state data; estimation indicator storage means which stores an error estimation indicator; and estimated data producing means which performs an error estimation process on data input to the correction processing means based on the error estimation indicator stored in the estimation indicator storage means in response to detection of the remaining error by the detection means, and produces estimated data based on data input to the correction processing means, wherein when the estimated data producing means produces estimated data, the correction processing means accepts input of the estimated data instead of the supply data, and performs the error correction process on the estimated data.

According to Claim 10, the error correcting method for performing an error correction process on supply data supplied from an information source, features including: a correction processing step for accepting input of the supply data, performing an error correction process on the supply data, and producing corrected data based on the input data and error-state data showing a status of a remaining error in the corrected data, a detection step for detecting the remaining error included in the corrected data based on the error-state data; an estimation indicator storage step for storing an error estimation indicator in an estimation indicator storage portion; and an estimated data producing step for performing an error estimation process on data input at the correction processing step based on the error estimation indicator stored in the estimation indicator storage portion in response to detection of the remaining error according to the detection step, and producing estimated data based on the input data, wherein the correction processing step includes accepting input of the estimated data instead of the supply data, and performing the error correction process on the estimated data when the estimated data is produced.

### Brief Description of the Drawings

FIG. 1 is a block diagram showing a configuration of an error correcting device according to an embodiment of the present invention.
FIG. 2 is a flowchart showing a processing program for the error correcting device of FIG. 1.
FIG. 3 is a flowchart showing a subroutine program in connection with an error estimation process of FIG. 2.
FIG. 4 is a timing diagram showing a processing cycle of a microprocessor in the error correcting device of FIG. 1.
FIG. 5 is a block diagram showing a configuration of a data receiving device which is an example embodying the present invention.
FIG. 6 is a table showing cases which make indicators in performing an error block estimation process when there is an error in a header portion of a data stream.
FIG. 7 is a table showing cases which make indicators in performing the error block estimation process when there is an error in a data portion of a data stream.
FIG. 8 is a flowchart showing a second example of an error correction processing program for the data receiving device in FIG. 5.
FIG. 9 is a table showing cases which make indicators in performing an error block estimation process on a data stream of MPEG4.

### Mode for Carrying Out the Invention

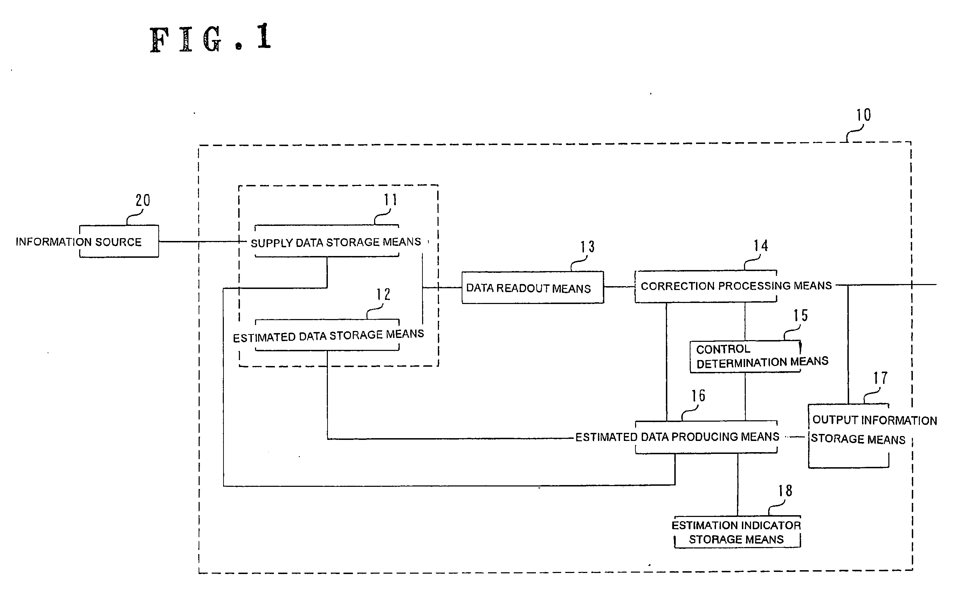

Referring to FIG. 1, there is shown an error correcting device according to the present invention.

The error correcting device 10 in the drawing is an error correcting device according to an embodiment of the present invention. The information source 20 is a portion to supply data to the error correcting device 10, which may be, for instance, various types of broadcast media including a terrestrial digital broadcast and a satellite broadcast or various kinds of recording media including an optical disk.

The supply data storage means 11 is a portion to temporarily accumulate supplied data when the data that the information source 20 supplies is of a kind supplied successively at all times, such as received data coming from a broadcast media. However, when the information source 20 is a recording medium such as an optical disk, there is no need to particularly provide such buffering means, and the data may be acquired from the recording medium directly. The estimated data storage means 12 is a portion to temporarily accumulate estimated data produced by estimated data producing means 16, which is to be described later.

The data readout means 13 is a portion to read out data from the supply data storage means 11 or estimated data storage means 12 in a predetermined cycle intermittently. The method of reading out data may include, for instance, assuming that the supply data storage means 11 and the estimated data storage means 12 are memory circuits, addressing such memory circuits, and reading out desired data from the circuits.

The correction processing means 14 is a portion to perform a predetermined error correction process on a data stream that the data readout means 13 reads out from the supply data storage means 11 or the estimated data storage means 12.

The control determination means 15 is a portion to determine the presence or absence of a remaining error for the data stream after performing the error correction process by the correction processing means 14, and generally control operations of the individual means included in the error correcting device 10, such as the correction processing means 14 and estimated data producing means 16. Therefore, the control determination means 15 includes a microprocessor, a memory such as ROM or RAM, and respective circuits including peripheral circuits thereof, which are not shown in the drawing. In the memory, a main program which prescribes the operation of the error correcting device 10 and various kinds of subprograms are stored. The microprocessor executes the main program and subprograms step by step in synchronization with a signal of a built-in clock, whereby the various kinds of processes in the error correcting device 10 are executed.

The estimated data producing means 16 is a portion to produce an estimated data, which is to be described later, based on a predetermined algorithm. Specifically, in the case where even after the data readout means 13 has read out supply data from the supply data storage means 11 and then the correction processing means 14 has performed the error correction process, the error-corrected data still has an error, the estimated data producing means 16 operates as follows. First, the estimated data producing means 16 reads out the data in agreement with the supply data from the supply data storage means 11. Then, the means 16 uses the data as a base to produce estimated data, and has the estimated data storage means 12 store the estimated data.

On the other hand, in the case where even after estimated data has been read out from the estimated data storage means 12 and then error correction process has been performed, the error-corrected data still has an error, the estimated data producing means 16 reads out data in agreement with the estimated data from the estimated data storage means 12. Then, the estimated data producing means 16 produces new estimated data based on the read data, and has the estimated data storage means 12 store the newly produced estimated data. Incidentally, as the data readout means 13 includes a predetermined a data buffer, the data readout means may be arranged so that it reads out data from the buffer and produces estimated data when the error-corrected data still has an error.

The output information storage means 17 is a portion to appropriately store information required for a process of producing estimated data, such as a TS flag contained in the correct data after the error correction that the correction processing means 14 outputs.

The estimation indicator storage means 18 is a portion for storing a case which makes an indicator for determination of data error estimation and also becomes an indicator for performing the error estimation process. The estimated data producing means 16 refers to various types of estimation indicator patterns previously stored in the estimation indicator storage means 18, estimates an error block, and produces estimated data.

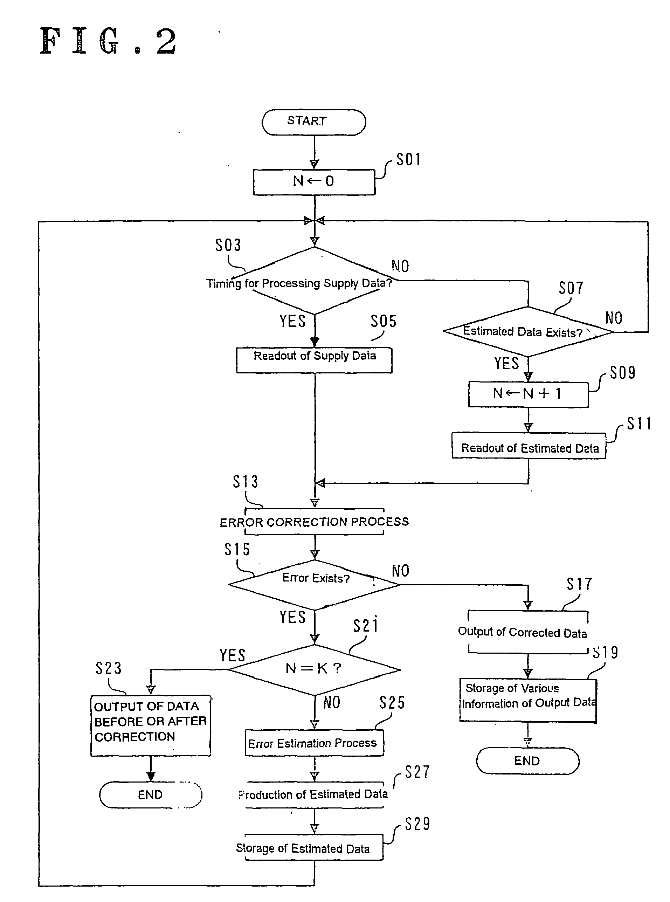

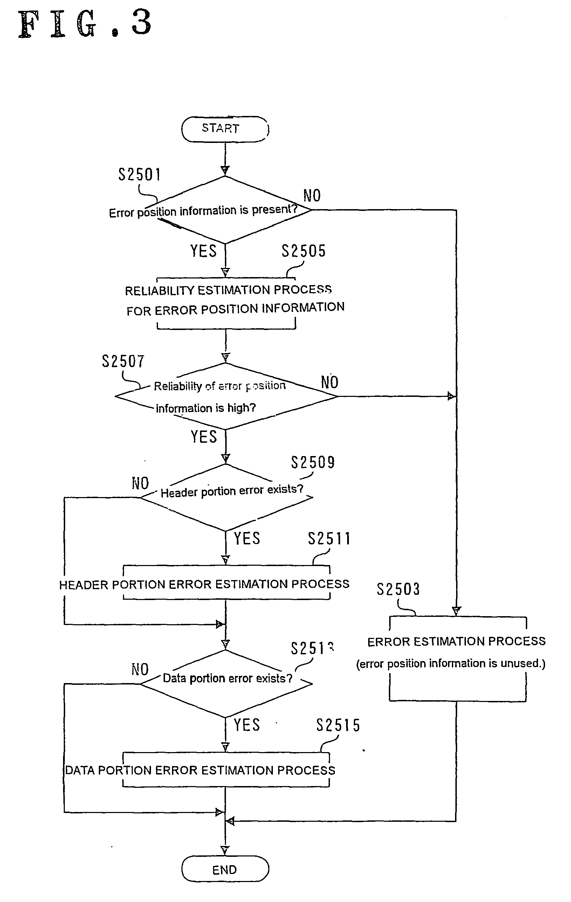

Now, the operation of the error correcting device 10 shown in FIG. 1 will be described with reference to flowcharts shown in FIGs. 2 and 3. The programs shown by the flowcharts are stored in a memory in the control determination means 15, and are executed by a microprocessor built in the control determination means 15.

First the program shown in FIG. 2 is started at a predetermined timing. Then, at Step S01 the microprocessor initializes a count value N of a processing counter, which is provided in a predetermined region on RAM of the memory, thereby to make the count value zero(0). Then, the microprocessor proceeds to subsequent Step S03, and determines whether or not the time fits the timing for performing processing of supply data. In other words, as described on the above configuration of the error correcting device 10, in a course that the data readout means 13 reads out supply data from the supply data storage means 11 intermittently and deals with the supply data, it is determined at this step whether or not the time fits the timing for starting execution of the process.

When it is determined at Step S03 that the time fits the timing for executing the process of supply data, the microprocessor proceeds to Step S05, and issues an instruction to read out the predetermined supply data out of the supply data storage means 11 to the data readout means 13. Now, in the case where the information source 20 is a recording medium such as an optical disk, the supply data may be read out from the recording medium directly.

On the other hand, when it is determined at Step S03 that the time does not fit the timing for processing supply data, the microprocessor proceeds to Step S07 , and determines whether or not estimated data has been stored in the estimated data storage means 12. Then, when no estimated data has been stored in the estimated data storage means 12, the microprocessor goes back to Step S03 and repeats the above process. However, when estimated data has been stored, the microprocessor proceeds to Step S09, increments the count value N of the processing counter, and issues an instruction to read out predetermined estimated data out of the estimated data storage means 12 to the data readout means 13 at subsequent Step S11.

When the Step S05 or Step S11 is terminated, the microprocessor proceeds to an error correction process of Step S13, and issues the correction processing means 14 with an instruction to execute the predetermined error correction process on a data stream that the data readout means 13 reads out. Incidentally, the description on such error correction process is omitted here because a variety of existing error correction processing methods can be used.

When the error correction process of Step S13 is terminated, the microprocessor determines at subsequent Step S15 whether or not the error-corrected data has a remaining error. If there is no error, the microprocessor outputs the data to an external apparatus (not shown) in the subsequent stage as output data of the error correcting device 10 (Step S17). Also, the microprocessor makes the output information storage means 17 store the states of various kinds of flags e.g. TS flag, included in the output data (Step S19), and terminates the process involved in the program shown in FIG. 2.

On the other hand, when it is determined at Step S15 that error-corrected data still has a remaining error, the microprocessor proceeds to Step S21, and determines whether or not the count value N has reached a predetermined number of times K.

Now, a method of setting the predetermined number of times K will be described below.

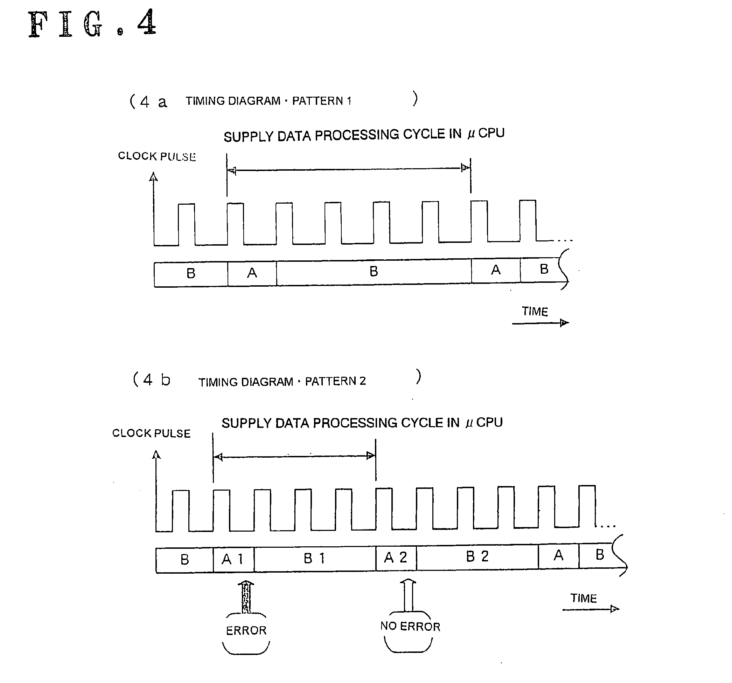

First, as shown in the timing diagram of Pattern 1 of FIG. 4(a), in the period of one cycle of the supply data processing by the microprocessor, a period actually required for the error correction process of supply data is denoted by A, and a remaining period subsequent to the actually required period is denoted by B. When the data after the error correction process still has an error, the error estimation process is required to be completed within the remaining period B, and therefore the number of error estimation processes which can be executed during the remaining period B is set as K.

For instance, in the case of assuming that the period required for the error estimation process has a length of time equal to the period A, when a load to the microprocessor in one cycle of the supply data processing is 20% or smaller as shown in FIG. 4A, K = (Period B/ Period A) and therefore K can be set as K =4. The waveform and frequency of a clock pulse shown in the drawing are merely intended to schematically represent a clock pulse supplied to the microprocessor. The pulse cycle shown in the drawing does not show an actual processing time directly.

In addition to the description which has been presented above, the predetermined number of times K may be set as in the timing diagram of Pattern 2 shown in FIG. 4 (b). FIG. 4 (b) shows a method such that in the case where there is an error in an error correction processing period A1, whereas there is no error in an error correction processing period A2 of the processing cycle subsequent to the period A1, when the error estimation process in association with A1 is not terminated during the period B1, the subsequent period B2 of the processing cycle is utilized to continue the estimation process. In this case, the error estimation process can be continued until the error-corrected data is used in e.g. a decoder circuit (not shown) in the subsequent stage of the error correcting device. Accordingly, in this case, a larger numeric value can be set as the predetermined number of times K in comparison to the case of Pattern 1 of FIG. 4(a).

As for an error correcting device of a broadcast receiver or the like, in recording error-corrected data on a recording medium or the like inside the receiver, the error estimation process may be repeated without setting the predetermined number of times K until data with no error is obtained finally.

When it is determined at Step S21 that the count value N has reached the predetermined value K, the microprocessor proceeds to Step S23. Then, the microprocessor outputs the corrected data or data before correction at that time as output data of the error correcting device 10 to the external apparatus (not shown) in the subsequent stage, and terminates the process involved in the program shown in FIG. 2.

However, when it is determined at Step S21 that the count value N has not reached the predetermined value K, the microprocessor proceeds to Step S25, and issues an instruction to execute the error estimation process to the estimated data producing means 16. The error estimation process at Step S25 may a process of merely performing either an error estimation process of a header portion or an error estimation process of a data portion on a data stream. Otherwise, it may be a process of performing a combination of the estimations. A processing method including a combination of the estimations is shown by the flowchart of FIG. 3.

First, at Step S2501 of FIG. 3, the microprocessor determines whether or not information about an error position in a data stream is shown in the light of the case where information about an error position in a data stream is not shown. In the case where the error position information is not shown, the microprocessor proceeds to Step S2503, and executes the error estimation process on all the data streams without using error position information. Also, as for the error estimation process in this case, the way of performing error estimation on either a header portion or a data portion may be adopted, or otherwise the way of performing a combination of the error estimations may be adopted.

However, when it is determined at Step S2501 that error position information has been shown, the microprocessor proceeds to Step S2505, and executes a reliability estimation process for error position information.

The reliability estimation process for error position information is a process of determining whether or not error position information is reliable. For instance, as described above, error correction by RS (204, 188) code allows information on positions (error position information) of up to 16 error blocks to be detected. When the number of error block is 17 or larger, error position information is detected for not more than 16 blocks. On this account, in such case the error position information will be incorrect. Then, the reliability of error position information matters. As a method of estimating the reliability of error position information, there is a method of determining whether or not a data stream at an error position that error position information indicates has not an error but correct information. Specifically, when it is estimated that there is correct data rather than an error in a data stream at an error position that error position information indicates, it is estimated that the error position information is incorrect, i.e. the reliability is low. In this case, the process may be simplified by not checking a block that the error position information indicates, but checking only e.g. a portion of the block or a header portion.

After terminating the reliability estimation process for error position information, the microprocessor proceeds to Step S2507, and makes determination on the result of estimation of the reliability of error position information by the process at Step S2505. Then, when it has been estimated at Step S2505 that the reliability of error position information is low (or not high), the microprocessor proceeds to Step S2503 and executes the process at the step which has been described above. On the other hand, when it has been estimated at Step S2505 that the reliability of error position information is high, the microprocessor proceeds to Step S2509 and determines whether or not the header portion has an error block that the error position information indicates.

When it is determined at Step S2509 that the header portion has an error, the microprocessor proceeds to subsequent Step S2511, and executes the error estimation process on the header portion. For the process of estimating an error in a header portion, a variety of existing methods for such estimation process can be used, and the description thereof is omitted here.

On the other hand, when it is determined at Step S2509 that the header portion has no error, or when the process at Step S2511 is terminated, the microprocessor proceeds to Step S2513, and determines whether or not the data portion has an error block that the error position information indicates. Then, when it is determined that the data portion has an error, the microprocessor proceeds to subsequent Step S2515 and executes the error estimation process on the data portion. Also, as for the process of estimating an error in a data portion, a variety of existing methods for such error estimation process can be utilized, and the description thereof is omitted here.

On the other hand, when it is determined at Step S2513 that the data portion has no error, or when the process at Step S2515 is terminated, the microprocessor terminates the process shown in the flowchart of FIG. 2, i.e. the error estimation process at Step S25 in FIG. 2.

After that, the microprocessor makes the estimated data producing means 16 produce estimated data based on the result of the error estimation process at Step S25 (Step S27), has resulting data stored in the estimated data storage means 12 (Step S29), returns to Step S03 of FIG. 3, and then repeats the operations which have been described above.

### FIRST EMBODIMENT

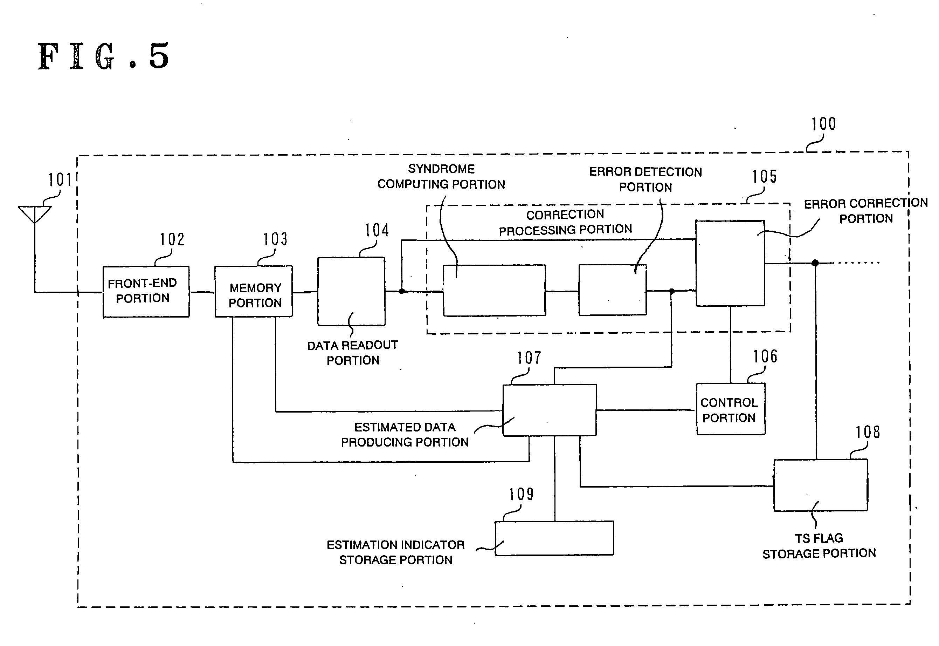

Referring now to FIG. 5, there is shown a receiving device including an error correcting device according to the present invention. The receiving device 100 is a receiver which receives a digital broadcast, e.g. BS, CS, or terrestrial digital broadcast, and demodulates and reproduces digital data contained in the broadcast. The receiving device 100 includes circuits of a reproduction-and-output portion or the like; the reproduction-and-output portion converts and reproduces demodulated data into image and audio signals, which allows a user to watch and listen to the broadcast, and outputs the resulting signals. However, the description and description of the circuits are omitted because such circuits are not directly pertinent to the present invention.

The configuration of the receiving device 100 will be described, first.

The antenna 101 is e.g. a parabolic antenna and an offset antenna, and in a vehicle-mounted receiver the antenna 101 is one for receiving a digital broadcast, such as a dipole antenna or a film antenna, which is mounted on a vehicle. The antenna 101 is a portion which receives a digital broadcasting radio wave and supplies the radio wave to a front-end portion 102.

The front-end portion 102 is a portion which converts in frequency and demodulates a broadcasting radio wave like this, and converts digital data superposed on the radio wave into time series of data e.g. an MPEG transport stream, thereby extracting the data.

The combination of a memory portion 103 and a data readout portion 104 is a section for storing received data supplied from the front-end portion 102 and estimated data supplied from an estimated data producing portion 107 to be described later and supplying the stored data to a correction processing portion 105 with a predetermined timing. It is not necessary for the data readout portion 104 to have a configuration such that it is separated from the memory portion 103 particularly. The data readout portion may have a configuration such that it is incorporated in the memory as an addressing circuit of the memory portion 103. In addition, the timing of data supply is controlled by a control portion 106 which is to be described later.

The correction processing portion 105 is a portion which performs the predetermined error correction process on time series of data supplied from the memory portion 103, and which can take on various forms according to an error correction code contained in the time series of data. Incidentally, the case or instance of FIG. 5 shows the case of using the RS code as an error correction code, wherein the correction processing portion 105 primarily includes: a syndrome computing portion which computes syndrome information showing whether or not there is an error in a symbol of the targeted time series of data; an error detection portion which determines, on the basis of the information, an error correction pattern and error position information; an error correction portion which performs error correction of the targeted time series of data on the basis of such correction pattern and position information, and the correction processing portion performs error correction by RS (204, 188) code.

In the meantime, error-corrected data output from the correction processing portion 105 is supplied to various received-data-processing circuits (not shown) provided in the subsequent stage of the correction processing portion 105. Now, it is noted that various kinds of descriptors such as TS flag, which are included in corrected data and show data states, are recorded in a TS flag storage portion 108 sequentially.

The control portion 106 includes microprocessor, which is not shown in the drawing, a memory circuit, such as ROM or RAM and their peripheral circuits, and is a portion which performs centralized control of the entire receiving device 100. In the memory circuit, a main program for prescribing the operations of the receiving device 100 and various kinds of subprograms are stored. The microprocessor executes the programs in synchronization with its built-in clock step by step, whereby various kinds of processes in the receiving device 100 are executed.

The estimated data producing portion 107 is a portion which acquires various information and data from other constituent portions including the correction processing portion 105 and TS flag storage portion 108 on the basis of an instruction from the control portion 106, adjusts a time-series of bits of the demodulated received data, and produces a time-series of bits of estimated data.

The estimation indicator storage portion 109 is connected to the estimated data producing portion 107, and a portion in which cases or examples are stored, each of the examples being an indicator or measure in performing the error estimation process when the estimated data producing portion 107 produces estimated data. Specifically, the estimated data producing portion 107 refers to various types of estimation indicator patterns previously stored in the estimation indicator storage portion 109, estimates the error block, and produces estimated data.

A combination of the antenna 101 and the front-end portion 102 corresponds to the information source 20 according to the embodiment of the present invention shown in FIG. 1, and the memory portion 103 corresponds to a combination of the supply data storage means 11 and the estimated data storage means 12. Likewise, the data readout portion 104, the correction processing portion 105, the control portion 106, the estimated data producing portion 107 and the TS flag storage portion 108 correspond to the data readout means 13, the correction processing means 14, the control determination means 15, the estimated data producing means 16 and the output information storage means 17, respectively. Also, the estimation indicator storage portion 109 corresponds to the estimation indicator storage means 18.

In the following description, a description will be made taking a standard of ARIB STD-B31 "Digital Terrestrial Television Broadcasting Transmission System" as an example, and the data format shall be in conformity with ARIB STD-B24 and ISO/IEC13818-1.

Next, the operation for a process of correcting an error in received data in the embodiment will be described. As the operations for the process in the embodiment are the same as those in the above-described embodiment according to the present invention, the description will be presented with reference to the flowcharts of FIGs. 2 and 3.

Specifically, when the processing program shown by FIG. 2 is initiated in the receiving device 100, the microprocessor of the control portion 106 initializes the count value N of the processing counter provided in a predetermined region on RAM of the memory thereby to make the count value zero (0) at Step S01. Then, the microprocessor proceeds to subsequent Step S03, and determines whether or not the time fits the timing (i.e., it is the time) for performing processing of supply data. That is, in a course that the data readout portion 104 reads out data from the memory portion 103 intermittently and deals with the data, it is determined at this step whether or not the time fits the timing for starting execution of the process.

When it is determined at Step S03 that the it the time for execution of the supply data processing, the microprocessor proceeds to Step S05, and issues the data readout portion 104 with an instruction to read out predetermined supply data from the memory portion 103. Here, the predetermined supply data means received data which is supplied by the front-end portion 102. The control portion 106 performs addressing of the memory portion 103, received data from the front-end portion 102 is supplied to the correction processing portion 105 through the data readout portion 104.

On the other hand, when it is determined at Step S03 that the time does not fit the timing for processing supply data (received data), the microprocessor proceeds to Step S07, and determines whether or not estimated data from the estimated data producing portion 107 is stored in the memory portion 103. Then, when the estimated data is not stored in the memory portion 103, the microprocessor returns to Step S03 and repeats the above-described process. In contrast, when estimated data is stored, the microprocessor proceeds to Step S09, and increments the count value N of the processing counter. At subsequent Step S11 the microprocessor issues the data readout portion 104 with an instruction to read out predetermined estimated data from the memory portion 103.

When the Step S05 or S11 is terminated, the microprocessor proceeds to the error correction process at Step S13, and issues the correction processing portion 105 with an instruction to execute the predetermined error correction process on a data stream read by the data readout portion 104.

In the correction processing portion 105, syndrome information showing whether or not there is an error in a symbol of time series of data input by the syndrome computing portion is computed first. Subsequently, the error detection portion determines an error correction pattern and error position information on the basis of the syndrome information. Then, in the error correction portion in the subsequent stage, the error correction process is performed on the targeted time series of data on the basis of the correction pattern and position information relevant to such error. Thus, the data after error correction and error correction result information are determined. Here, the error correction result information means a signal including information showing, by means of e.g. a flag bit or a status code, whether or not error correction has been done satisfactorily. The error position information and the error correction result information are notified from the correction processing portion 105 to the control portion 106.

When the error correction process at Step S13 is terminated, the microprocessor determines at subsequent Step S15 whether or not there is a remaining error in data after the error correction process. When there is no error, the data is output to the circuit (not shown) in the subsequent stage as output data of the correction processing portion 105 (Step S17). The microprocessor has the states of various kinds of flags, e.g. TS flag, included in the output data stored in the TS flag storage portion 108 (Step S19), and terminates the process involved in the program of FIG. 2.

On the other hand, when it is determined at Step S15 that there is a remaining error in the data after the error correction process, the microprocessor proceeds to Step S21, and determines whether or not the count value N has reached the predetermined number of times K. As the method of setting the predetermined number of times K is the same as that stated above, the description thereof is omitted here.

When it is determined at Step S21 that the count value N has reached the predetermined value K, the microprocessor proceeds to Step S23 , outputs the uncorrected or corrected data at that point to the circuit (not shown) in the subsequent stage as output data of the correction processing portion 105, and terminates the process shown in FIG. 2.

On the other hand, when it is determined at Step S21 that the count value N has not reached the predetermined value K, the microprocessor proceeds to Step S25, and issues an instruction to the estimated data producing portion 107 to execute the error estimation process. The error estimation process may comply with a processing method of merely performing either an error estimation process of a header portion or an error estimation process of a data portion on a data stream. Otherwise, it may comply with a processing method of performing a combination of the estimations. The operations according to a method including a combination of the estimations are shown by the flowchart of FIG. 3.

First, at Step S2501 of FIG. 3, the microprocessor determines whether or not information about an error position is shown in data in the light of the case where information about an error position in a data stream is not shown. Incidentally, as the correction processing portion 105 in the embodiment performs error correction by RS (204, 188) code, the information about an error position is shown.

Then, the microprocessor proceeds to Step S2505, and executes the reliability estimation process for error position information.

The reliability estimation process for error position information is a process of estimating whether or not information about an error position is reliable. The description of the reliability estimation process is as stated above.

After terminating the reliability estimation process for error position information, the microprocessor proceeds to Step S2507, and makes determination on the result of estimation of the reliability of error position information by the process at Step S2505. Then, when it has been estimated at Step S2505 that the reliability of error position information is low, the microprocessor proceeds to Step S2503 and executes the process at the step which has been described above. On the other hand, when it has been estimated at Step S2505 that the reliability of error position information is high, the microprocessor proceeds to Step S2509 and determines whether or not the header portion has an error block that the error position information indicates.

On this occasion, the control portion 106 sends out an instruction to acquire various information and/or received data to the estimated data producing portion 107. On the basis of such acquisition instruction, the estimated data producing portion 107 obtains received data, error position information, and TS flag information, etc. from the front-end portion 102, the error detection portion of the correction processing portion 105, and the TS flag storage portion 108, respectively. The TS flag information is what various kinds of state descriptors which have been included in a MPEG transport stream (hereinafter, simply referred to as "MPEG-TS") of received data are generically referred to as, and refers to such state descriptors collectively, provided that error correction for the received data has been made normally until that moment. In addition, the control portion 106 analyzes the error position information acquired through the estimated data producing portion 107, and determines whether or not there is an error portion in a header portion of MPEG-TS.

When it is determined at Step S2509 that the header portion has an error, the microprocessor proceeds to subsequent Step S2511, and outputs an instruction to execute the error estimation process for the header portion to the estimated data producing portion 107.

On receipt of the instruction, the estimated data producing portion 107 compares acquired received data with TS flag information to produce estimated data. Examples of a method of producing estimated data when a header portion of MPEG-TS has an error include the following. The first is a method such that when a synchronous byte of a header portion is not "0×47," the byte is corrected to "0×47." The second is a method such that an error in a predetermined block is estimated in the case where a payload unit start indicator is one(1), the case where adaptation field control is undefined, or the case where the starting point of a payload is not coincident with the starting point of a PES section in spite of an adaptation field only.

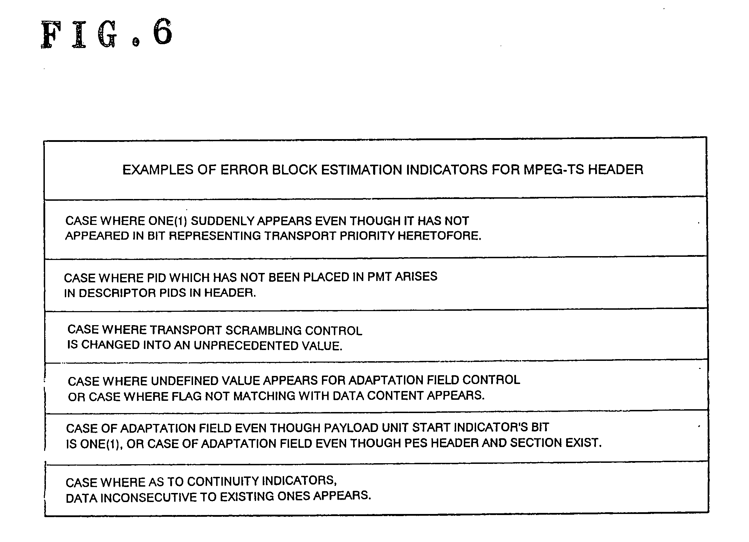

In other words, when a code of an 0/1 pattern which would never appear in a typical time-series of bits of received data is detected, the block is estimated to be an error block, whereby the error block estimation is performed. As for the indicator to perform the error block estimation, various indicators as listed in the table of FIG. 6, for instance, are possible except the above-described examples. It is needless to say that the error estimation indicators which have described above are just exemplified, and the embodiment of the present invention is not limited to the examples. The error estimation indicators for a header portion, which have been described above, are stored in advance in the estimation indicator storage portion 109, and the estimated data producing portion 107 reads out and utilizes the indicators appropriately on an as-needed basis.

On the other hand, when it is determined at Step S2509 that there is no error in a header portion, or when the process at Step S2511 is terminated, the microprocessor proceeds to Step S2513, and determines whether or not there is an error block that the error position information indicates in a data portion.

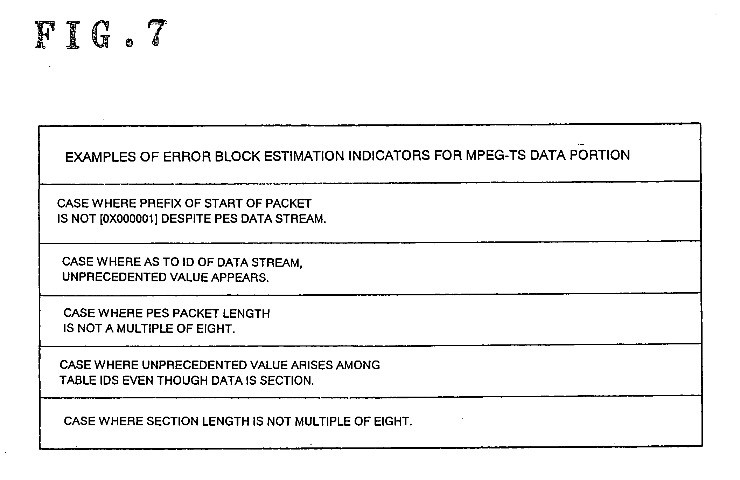

When it is determined that there is an error in a data portion of MPEG-TS, the control portion 106 proceeds to Step S2515, and outputs an instruction to execute the error estimation process on the data portion to the estimated data producing portion 107. On receipt of the instruction, the estimated data producing portion 107 compares acquired received data with TS flag information, produces estimated data, and performs error block estimation. In the case where there is a block which is not made NULL in spite of NULL portion, for instance, the error block estimation is performed by making the block NULL. As other indicators for performing the error block estimation on a data portion, the examples as shown in FIG. 7 are possible, for instance. However, it is needless to say that such error estimation indicators are just exemplified, and an embodiment of the present invention is not limited to the examples. The error estimation indicators for a data portion, which have been described above, have been stored in the estimation indicator storage portion 109 previously. The estimated data producing portion 107 reads out and utilizes the indicators appropriately on an as-needed basis.

On the other hand, when it is determined at Step S2513 that there is no error in a data portion, or when the process at Step S2515 is terminated, the microprocessor terminates the process shown by the flowchart of FIG. 3, i.e. the error estimation process at Step S25 of FIG. 2.

After that, on the basis of the result of the error estimation process at Step S25, the microprocessor makes the estimated data producing portion 107 produce estimated data (Step S27), and makes the memory portion 103 store the data (Step S29). Then, the microprocessor returns to the aforementioned Step S03 and repeats the procedures of the process which have been described above.

As described above, according to the embodiment, an error block in time-series of bits of received data is estimated, and the block is adjusted into a bit pattern which can be taken on typically. Then, the error correction process is repeated again. Therefore, even if there are errors more than error blocks, which have been impossible to correct in a prior art, it becomes possible to correct the error or detect an error position thereof.

### SECOND EMBODIMENT

Now, a second embodiment in which error block estimation is performed when there is an error in a data portion of MPEG-TS and the data portion thereof has no NULL portion will be described.

That is, after it has been determined at Step S2513 of FIG. 3 in the first embodiment that there is an error in a data portion, determination on the presence or absence of NULL portion in the data portion is made. Then, a process according to the embodiment will be performed when there is no NULL portion, whereas the above-described error estimation process will be performed on the data portion when there is a NULL portion. Accordingly, the processing course until the microprocessor reaches a processing course according to the embodiment is the same as that in the first embodiment. Also, the configuration of a data receiving device according to the embodiment is the same as that of the receiving device 100 in the first embodiment.

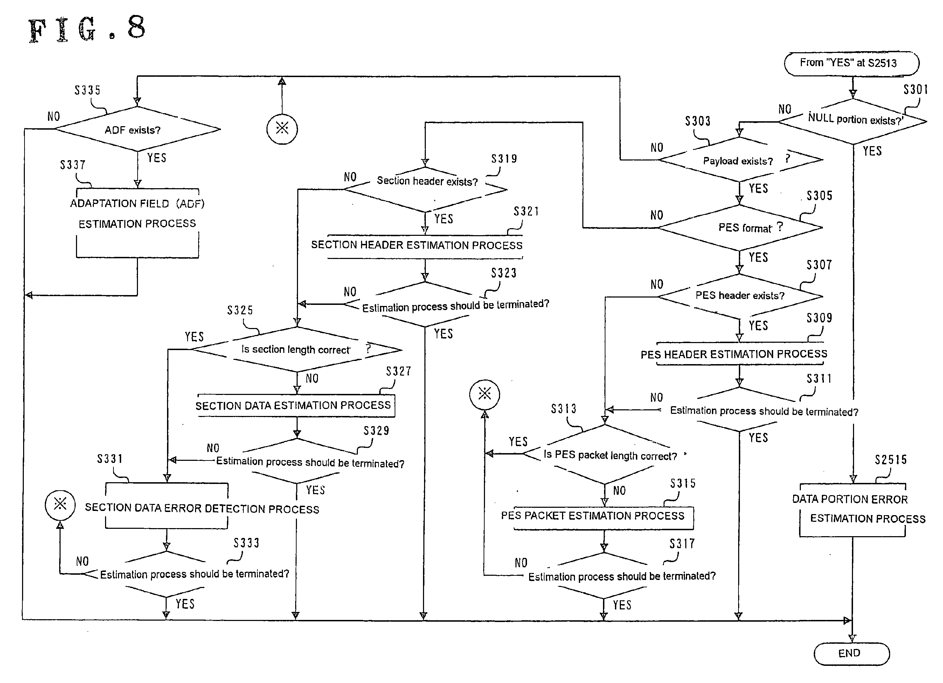

A flowchart of a processing program according to the embodiment is shown in FIG. 8.

First, when it is determined at Step S301 of FIG. 8 that there is a NULL portion in a data portion of the MPEG-TS, the microprocessor of the control portion 106 goes to Step S2515 of FIG. 3, and executes the above-described error estimation process on the data portion. When the process is completed, the microprocessor terminates the process of FIG. 8, i.e. the process of FIG. 3.

However, when it is determined at Step S301 that there is no NULL portion in a data portion, the microprocessor goes to Step S303, and determines whether or not a payload is included in a data portion.

When it is determined at Step S303 that no payload is included in a data portion, the microprocessor transfers to Step S335, and determines whether or not an adaptation field (ADF) is included in a data portion. Then, when it is determined that no adaptation field is included in a data portion, the microprocessor terminates the process of FIGS. 8 and 3. Now, it is noted that a payload refers to a portion on which typical transmission data such as PES and a section are superposed in a data portion of MPEG-TS, and an adaptation field refers to a portion on which particular data, e.g. time information, except such typical data are superposed.

However, when it is determined at Step S335 that an adaptation field is included in a data portion, the microprocessor executes the error block estimation process (Step S337) on the adaptation field complying with a predetermined procedure and then terminates the process of FIGs . 8 and 3.

Next, the description on a process in the case where a payload is included in a data portion of MPEG-TS will be presented. In this case, the microprocessor transfers from Step S303 to Step S305, and determines whether or not the data superposed on the payload is in PES format. Now, it is noted that PES(Packetized Elementary Stream) format refers to one of data stream formats in transmission of data such as video data and audio data in MPEG2. In the descriptions below, the process in the case where data has been determined at Step S305 to be in PES format (from Step S307 onward) will be described first. After that, the process in the case where data has been determined not to be in PES format (from Step S319 onward) will be described.

The process in the case where data has been determined to be in PES format is described, initially.

When data on a payload is determined to be in PES format, the microprocessor transfers to Step S307, and determines whether or not there is a PES header. When it is determined that there is a PES header, the microprocessor transfers to Step S309, and perform a predetermined PES header estimation process. Then, at subsequent Step S311 the microprocessor determines whether to continue the estimation process or to terminate it.

For instance, in the case where the reliability of error position information is estimated to be high, the following arrangement may be made. That is, the number of blocks which has undergone error estimation by the estimation process is subtracted from the number of blocks obtained from the error position information. Then, the determination on whether to continue or terminate the estimation process is made depending on whether or not the resulting difference falls within a range of the block number which enables the correction by the correction processing portion 105. Alternatively, the estimation process may be continued consistently, or terminated at all times without making the determination on whether to continue/terminate the estimation process.

When it is determined at Step S311 that the estimation process should be terminated, the microprocessor terminates the process of FIGs. 8 and 3.

However, when it is determined at Step S311 that the estimation process should be continued, or when it is determined at the Step S307 that no PES header is included, the microprocessor goes to Step S313, and determines whether or not the length of a data packet included in the PES data stream is correct.

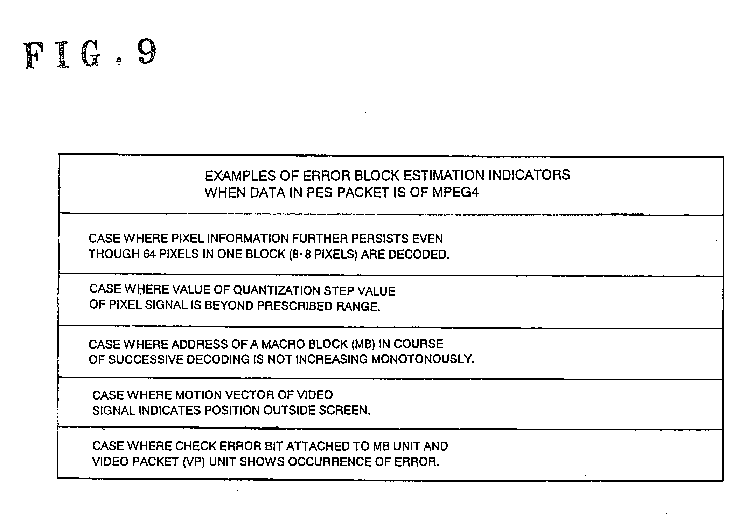

When it is determined at this step that the packet length is incorrect, the microprocessor goes to Step S315, and performs a predetermined PES packet estimation process thereby to estimate a data block in which an error is included. At Step S315, when data in the PES packet is of MPEG4, the estimation process is performed on the basis of error estimation indicators of MPEG4 shown in FIG. 9. Such error estimation indicators have been stored in the estimation indicator storage portion 109 in advance, and the estimated data producing portion 107 reads out and utilizes the indicators appropriately on an as-needed basis.

Thereafter, at Step S317 the microprocessor performs the same process as that at Step S311 which has been described above. Then, when it is determined that the estimation process should be terminated, the microprocessor terminates the process of FIGs. 8 and 3.

However, when it is determined at Step S317 that the estimation process should be continued, or when it is determined at above-described Step S313 that the PES packet length is correct, the microprocessor goes to the Step S335 , and repeats the aforementioned process from Step S335 onward.

Next, the process in the case where data is determined at Step S305 not to be in PES format (from Step S319 onward) will be described.

First, the microprocessor determines at Step S319 whether or not there is a section header in data. When it is determined that there is a section header, the microprocessor transfers to Step S321 and performs a predetermined section header estimation process. Then, at subsequent Step S323, the microprocessor makes the same determination as the aforementioned determination made at Step S311. When it is determined that the estimation process should be terminated, the microprocessor terminates the process of FIGs. 8 and 3.

However, when it is determined at Step S323 that the estimation process should be continued, or when it is determined at above Step S319 that there is no section header, the microprocessor goes to Step S325 and determines whether or not the length of a section included in a data stream is correct.

When it is determined at this step that the section length is incorrect, the microprocessor goes to Step S327 and performs a predetermined section data estimation process thereby to estimate a data stream in which an error is included. Then, at subsequent Step S329 the microprocessor makes the same determination as the aforementioned determination made at Step S311. When it is determined that the error estimation process should be terminated, the microprocessor terminates the process of FIGs. 8 and 3.

However, when it is determined at Step S329 that the error estimation process should be continued, or when it is determined at above Step S325 that the section length is correct, the microprocessor goes to Step S331, and executes a predetermined section data error detection process. Then, at subsequent Step S333, the microprocessor makes the same determination as the aforementioned determination made at Step S311. When it is determined that the estimation process should be terminated, the microprocessor terminates the process of FIGs. 8 and 3.

However, it is determined at Step S333 that the estimation process should be continued, the microprocessor goes to the above Step S335 and repeats the aforementioned process from Step S335 onward.

As described above, in the embodiment, the estimation process of an error block included in a data portion of MPEG-TS is performed in more detail in comparison to the first embodiment, which enables more accurate error estimation. Therefore, in regard to the correction processing portion 105, the error correcting function can be improved.

While in the above description the explanation has been made mainly taking a data stream configuration of MPEG2-TS as an example, the present invention is not limited to such embodiments. The present invention can be applied to a data stream on the basis of other format, e.g. MPEG2-PS.

## Claims

1. An error correcting device which executes an error correction process on supply data supplied from an information source, comprising:
correction processing means which accepts input of the supply data, performs an error correction process on the supply data, and produces corrected data based on the input data, and error-state data showing a status of a remaining error in the corrected data;
detection means which detects the remaining error included in the corrected data based on the error-state data;
estimation indicator storage means which stores an error estimation indicator; and
estimated data producing means which performs an error estimation process on data input to the correction processing means based on the error estimation indicator stored in the estimation indicator storage means in response to detection of the remaining error by the detection means, and produces estimated data based on data input to the correction processing means,
wherein when the estimated data producing means produces estimated data, the correction processing means accepts input of the estimated data instead of the supply data, and performs the error correction process on the estimated data.

2. The error correcting device according to claim 1, wherein
the estimation indicator storage means stores an error estimation indicator for a header portion, and
the estimated data producing means performs an error estimation process on a header portion of data input to the correction processing means based on the error estimation indicator for a header portion stored in the estimation indicator storage means.

3. The error correcting device according to claim 1 or 2, wherein
the estimation indicator storage means stores an error estimation indicator for a data portion, and
the estimated data producing means performs an error estimation process on a data portion of data input to the correction processing means based on the error estimation indicator for a data portion stored in the estimation indicator storage means.

4. The error correcting device according to any one of claims 1 to 3, wherein
the error-state data includes error position information showing a position where the remaining error included in the corrected data exists, and
the estimated data producing means performs an error estimation process on data input to the correction processing means based on the error position information.

5. The error correcting device according to claim 4, wherein
the estimated data producing means executes a reliability estimation process on the error position information, and
the estimated data producing means performs an error estimation process on data input to the correction processing means based on the error position information when a reliability of the error position information is estimated to be high.

6. The error correcting device according to claim 5, wherein the estimated data producing means performs an error estimation process on data input to the correction processing means without being based on the error position information when the reliability of error position information is estimated to be low according to the reliability estimation process.

7. The error correcting device according to any one of claims 1 to 6, further comprising:
output information storage means which stores a plurality of parameters showing a state of the corrected data when the detection means cannot detect the remaining error,
wherein the estimated data producing means performs the error estimation process or the reliability estimation process based on the plurality of parameters stored in the output information storage means.

8. The error correcting device according to any one of claims 1 to 7, further comprising:
supply data storage means which stores input data supplied from the information source;
estimated data storage means which stores the estimated data; and
readout means which reads out data from the supply data storage means or the estimated data storage means, and inputs the data to the correction processing means,
wherein in a case where data is stored in the estimated data storage means, the readout means reads out data from the estimated data storage means and inputs the data to the correction processing means when not reading out data from the supply data storage means.

9. The error correcting device according to any one of claims 1 to 8, wherein the correction processing means outputs the corrected data from the error correcting device when the detection means cannot the remaining error.

10. An error correcting method for performing an error correction process on supply data supplied from an information source, comprising:
a correction processing step for accepting input of the supply data, performing an error correction process on the supply data, and producing corrected data based on the input data and error-state data showing a status of a remaining error in the corrected data,
a detection step for detecting a remaining error included in the corrected data based on the error-state data;
an estimation indicator storage step for storing an error estimation indicator in an estimation indicator storage portion; and
an estimated data producing step for performing an error estimation process on data input at the correction processing step based on the error estimation indicator stored in the estimation indicator storage portion in response to detection of a remaining error according to the detection step, and producing estimated data based on the input data,
wherein the correction processing step includes accepting input of the estimated data instead of the supply data, and performing the error correction process on the estimated data when the estimated data is produced.

11. A computer-readable program **characterized by** making a computer execute the error correcting method according to claim 10.

12. A recording media **characterized by** recording the program according to claim 11.
